(19) Europäisches Patentamt
European Patent Office
Office européen des brevets

(11) EP 2 879 318 A1

(12) EUROPEAN PATENT APPLICATION

(43) Date of publication:
03.06.2015 Bulletin 2015/23

(51) Int Cl.:
H04L 1/00 (2006.01)          H03M 13/11 (2006.01)
H03M 13/27 (2006.01)         H04L 27/26 (2006.01)
H04L 5/00 (2006.01)

(21) Application number: 13195168.3

(22) Date of filing: 29.11.2013

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME

(71) Applicant: Panasonic Corporation
Kadoma-shi
Osaka 571-8501 (JP)

(72) Inventors:
• Klenner, Peter
  63225 Langen (DE)
• Ouchi, Mikihiro
  Osaka, 540-6207 (JP)

(74) Representative: Grünecker Patent- und
Rechtsanwälte
PartG mbB
Leopoldstraße 4
80802 München (DE)

(54) **Efficient component interleaving for rotated constellations with time-frequency slicing**

(57) The present invention relates to communication systems and methods that employ rotated constellations and time-frequency slicing in conjunction with quasi-cyclic LDPC codes and provides a transmitter and a receiver with a parallelisable component interleaver that allows for an efficient hardware implementation, as well as corresponding methods.

Fig. 13

## Description

### TECHNICAL FIELD

The present invention relates to the field of digital communications and more specifically to communication systems that employ rotated constellations in conjunction with quasi-cyclic LDPC codes.

### BACKGROUND OF THE INVENTION

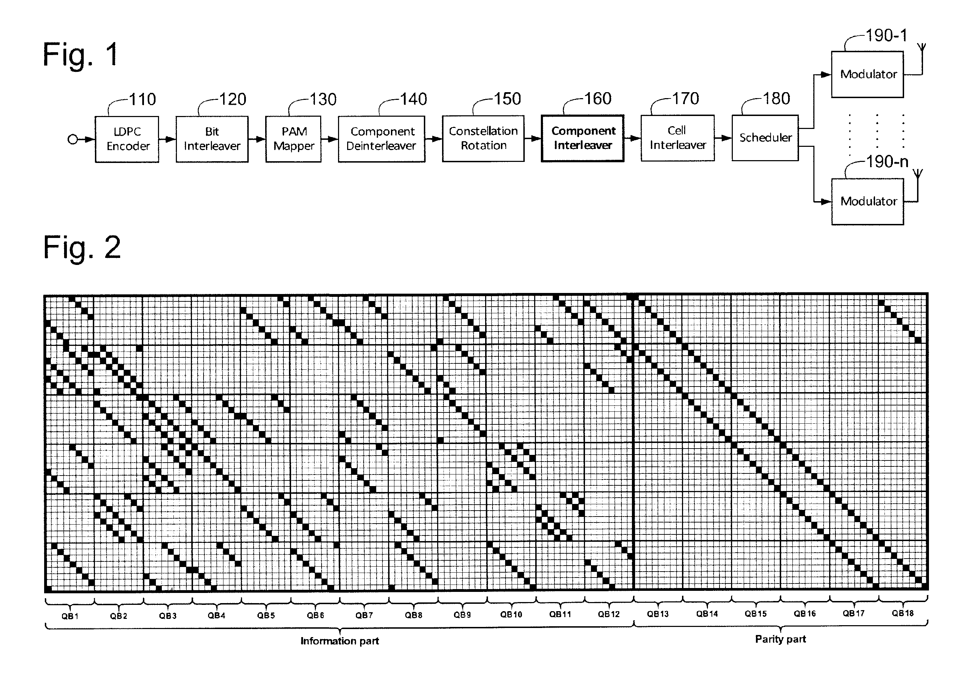

Figure 1 shows the block diagram of a generic transmitter that employs rotated constellations in conjunction with quasi-cyclic LDPC codes and Time-Frequency Slicing (TFS). The diagram is simplified to include only those blocks which are relevant to the invention.

The transmitter processes at its input binary blocks of a predetermined length, containing the information to be transmitted. Each information block is first encoded by an LDPC (low-density parity-check) encoder 110, the encoding process consisting in computing and adding redundancy bits in order to make the information block robust against errors.

The bits of the encoded LDPC codeword, thereafter referred to as an LDPC block, are then interleaved using a bit interleaver 120 and mapped onto real-valued PAM symbols by PAM mapper 130, which each encode a predefined number of bits, denoted here by B, such that a symbol takes a value from a discrete set of $2^B$ values. How the B bits are mapped to PAM symbols is well understood and not directly relevant to the present invention. The relevant aspect is that each FEC block is transformed into a block of real PAM symbols, which are subsequently paired into complex QAM symbols. The latter are frequently referred to as cells, and can be optionally permuted by a cell interleaver.

Two measures have been proven useful in order to increase the robustness over fading channels. The first measure is a dedicated transformation applied to the PAM mapper output, comprising a multiplication of vectors of D real PAM symbols with a DxD square orthogonal matrix. The PAM symbols in each vector can be regarded as identifying unique points in a D-dimensional space, the resulting $D^B$ combinations forming a D-dimensional constellation. The matrix multiplication can thus be regarded as a rotation in the D-dimensional space, hence the term rotated constellations. The constellation rotation is represented by block 150 in Fig. 1. The particular structure of the rotation matrix is not relevant to the present invention. Further details on rotated multi-dimensional constellations for improved diversity in fading channels are disclosed in co-pending European patent application No. 09168370.6.

The second measure is time-frequency-slicing which facilitates a distribution of FEC blocks not only in the time domain but also in the frequency domain by utilizing a set of distinct radio frequency (RF) channels. The rationale behind TFS is to increase diversity within a FEC block to allow successful decoding even if a large number of RF channels should be in a deep fade.

In order to achieve good performance with rotated constellations in connection with TFS it is essential that the D real components of each rotated constellation block be mapped to D different complex symbols, which are also referred to as cells. Moreover, the D components must be spread in time and frequency so that the channel fading they experience is as uncorrelated as possible. These aspects are well understood by the skilled person.

Referring to Figure 1, the PAM symbols pass through a cascade of component deinterleaver 140, constellation rotation 150, component interleaver 160, and cell interleaver 170. This cascade upholds the optimality of the cell interleaver 170 while maximizing the component separation which is disclosed in co-pending European patent application No. 12178274.2. Note, that the cells of each FEC block can be further spread in time and frequency by time and frequency interleavers (not shown), which may be placed between the cell interleaver 170 and the modulators 190-1...n.

Time-frequency slicing is performed by the scheduler 180 which slices the incoming cells of a FEC block into equi-sized partitions and distributes these onto a plurality of RF channels. This will be described in greater detail herebelow.

Finally, the complex symbols are modulated by modulators 190-1...n and transmitted over the communication medium. As a non-limiting example, the modulation scheme may be orthogonal frequency-division multiplexing (OFDM).

### Quasi-cyclic LDPC codes

As it is well known in the art, LDPC codes are linear error-correcting codes that are fully defined by a parity-check matrix (PCM), which is a binary sparse matrix that represents the connection of the codeword bits (also referred to as variable nodes) to the parity checks (also referred to as check nodes). The columns and the rows of the PCM correspond to the variable and the check nodes respectively. Connections of the variable nodes to the check nodes are represented by "1" entries in the PCM.

Quasi-cyclic (QC) LDPC codes have a structure that makes them particularly suited for hardware implementation. In fact, most if not all standards today use quasi-cyclic LDPC codes. The PCM of such a code has a special structure consisting of circulant matrices (also referred to as circulants). A circulant is a square matrix in which each row is a cyclic shift of the previous row by one position. It can have one, two, or more cyclically shifted diagonals. The size of each circulant is QxQ, where Q is referred to as the cyclic factor of the LDPC code. Such a quasi-cyclic structure allows Q check nodes to be processed in parallel, which is clearly advantageous for an efficient hardware implementation.

Figure 2 shows the PCM of an example LDPC code with a cyclic factor Q=8, the PCM having circulants with one or two diagonals. This code encodes a block of 8x12=96 bits to a codeword of 8x16=128 bits, having therefore a code rate of 2/3. The codeword bits are subdivided into blocks of Q bits, which will be referred to as cyclic blocks or quasi-cyclic blocks and denoted by QB throughout this document.

The code whose matrix is illustrated in Figure 2 belongs to a special family of QC LDPC codes known as repeat-accumulate (RA) QC LDPC codes. These codes are well known for their ease of encoding and are encountered in a large number of standards, such as the second-generation DVB standards: DVB-S2, DVB-T2, and DVB-C2. For these codes the right-hand side of the PCM, which corresponds to the parity bits, has a staircase structure.

**Parallel bit interleaver**

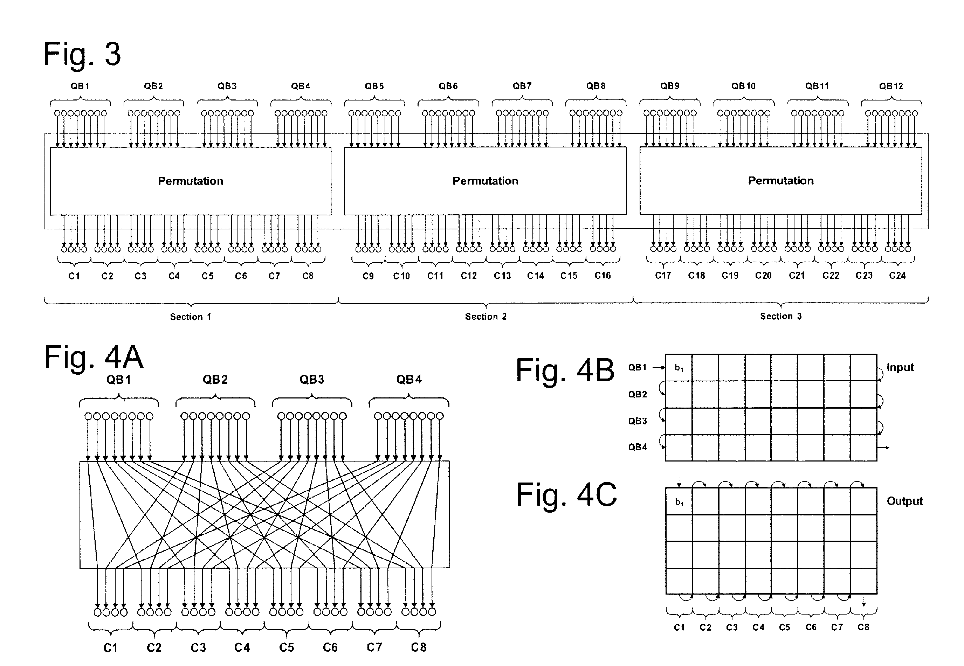

Reference EP 2 525 497 (A1) discloses a bit interleaver that is specifically adapted to the structure of a QC LDPC block. Figure 3 shows the structure of such an interleaver for an example LDPC code. This LDPC code has 12 QBs per codeword and 8 bits per QB (Q=8).

The QBs of an LDPC block are grouped into sections, each section being interleaved separately using a section permutation, as shown in Figure 4A. The number of QBs per interleaving section (4 in this example) is a parameter of the interleaver and will be denoted by M throughout this document. The section permutation is performed conceptually by writing the Q*M bits of each section row by row into a matrix with M rows and Q columns, as shown schematically in Fig. 4B, and reading them out column by column, as shown in Fig. 4C. Thus, the output of the section interleaver consists of groups of M bits, the M bits belonging to M different QBs of the original LDPC block. In a preferred embodiment, the parameter M may be chosen to be B*D, which is the number of bits for one real-valued vector in a rotated constellation block.

Prior to the grouping of the QBs into sections, the order of the QBs in the LDPC codeword can be changed according to a predefined permutation, referred to as QB permutation. Moreover, additional permutations can be applied to the Q bits of each QBs. These permutations are referred to as intra-QB permutations and are typically cyclic shifts, the shift value being different for each QB. The resulting structure is illustrated in Figure 5. These aspects are also disclosed in Reference EP 2 525 497 (A1).

While these two kinds of permutations are important for performance optimization, they are not directly relevant to the present invention. In fact, they can be regarded as part of the LDPC code definition. Thus, the QB permutation is equivalent to a permutation of the QB columns in the original PCM, whereas the intra-QB cyclic shifts increment modulo Q the original cyclic shifts of the diagonals in the PCM, the same cyclic shifts being applied to all diagonals in the same QB column.

**Rotated constellations in D dimensions**

Rotated constellations are an effective tool for improving the robustness of communication systems in channels with heavy fading and erasures. The underlying idea is to create signal space diversity by simultaneously transmitting binary information in multiple components. This is achieved by demultiplexing PAM symbols into vectors of length D, followed by applying an orthogonal matrix of dimension DxD to each vector and by component interleaving to separate the D components such that the individual components experience uncorrelated fading. Preferably, D is chosen as a power of 2 (usually 2 or 4).

In co-pending European patent application No. 12178270.0, a method for component interleaving in the context of constellation rotation is disclosed which is particularly optimized for the parallel bit-interleaver described above. In essence, the number of rows of a section is chosen to be equal to D and each row is cyclically shifted by Q/D PAM symbols. It is demonstrated in co-pending European patent application No. 12178270.0 that the resulting spread of the D cells after row-column cell interleaving is very even.

**Time-frequency-slicing (TFS)**

A further approach for increasing the reliability of a communication system is to exploit the diversity available over a plurality of RF channels, hereafter referred to as channel diversity. The main type of diversity is frequency diversity, which results from the fact that fading in wireless channels tends to be frequency selective and thus the fading correlation between any two RF channels is relatively low. Moreover, if the transmitters for the different RF channels are located in different geographical locations, also so-called spatial diversity is exploited. The channel diversity results therefore from both frequency and spatial diversity.

In order to enable the reception with a single tuner in the receiver, the information to be received continuously, e.g., a broadcast program, must not be sent over more than one RF channel at any given time. It is therefore necessary to use a sequence of frequency hops and time slices, i.e., a time-frequency slicing schedule, so that the receiver can hop from one frequency to the other and extract the desired data from each RF channel during the appropriate slice. The scheduling (time-frequency allocation) of the slices is typically signaled to the receiver through dedicated signaling information.

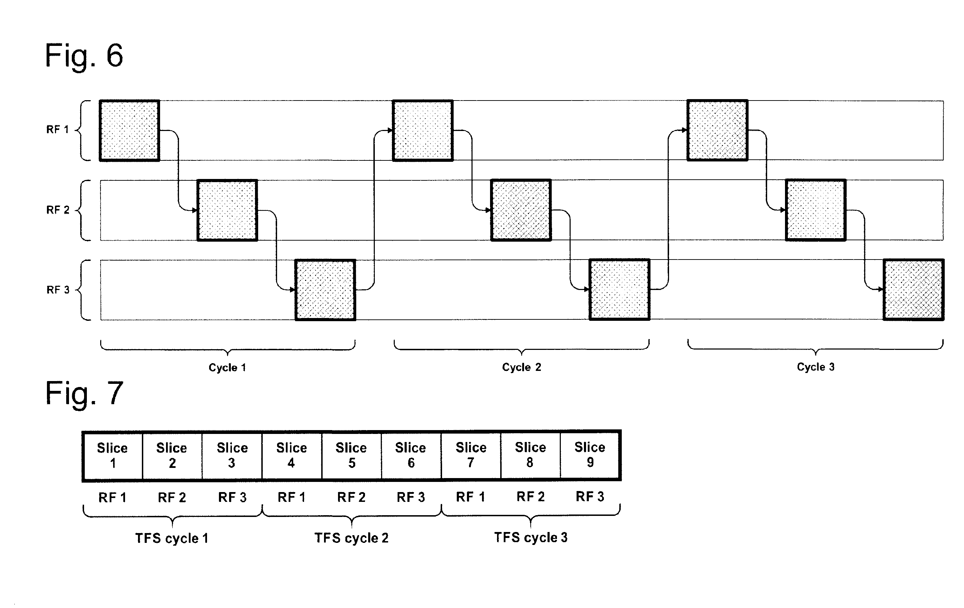

An example of TFS slicing and scheduling is shown in Figure 6 for three RF channels and three TFS hopping cycles. In order to allow the tuner to hop between two RF channels, a guard interval is required between two consecutive slices.

In the following, we denote the number of RF channels in a TFS multiplex by $N_{RF}$ and the number of TFS cycles over which a FEC block is spread by $N_C$. The number of slices over which a FEC block is spread is therefore $N_S=N_{RF}*N_C$. Optimal diversity is achieved when all slices have the same length and each FEC block has the same number of cells in all slices. Figure 7 shows how a FEC block is sliced for TFS with 3 RF channels and 3 cycles, corresponding to the TFS scheduling example in Figure 6. The slicing process is straightforward.

When rotated constellations are used in conjunction with TFS, the D cells must be mapped evenly onto the RF channels. For example, for D=2, the two cells must be mapped onto all possible pairs of RF channels, e.g., for 3 RF channels these pairs are: (1 &2), (1 &3), (2&3). Mapping the two cells onto the same RF channel must be avoided.

**Component Interleaver**

The component interleaver must ensure that the cells of a constellation block are 1) spread as evenly as possible over the interleaving duration, and 2) mapped to all possible combinations of RF channels for the TFS cases. If it is not possible to meet both conditions, the latter is to be preferred at the expense of the former. An example of a conventional component interleaver, provided by co-pending European patent application No. 12178270.0, will be described herebelow.

Figure 8 shows the layout of the bits in the section interleavers of the parallel bit interleaver of Figure 5 just before the mapping to PAM symbols.

Figure 9 is a schematic diagram of the process of mapping bits to rotated constellation blocks, exemplified for D=2, the first section interleaver, and the first rotated constellation block. Generally, this process comprises the three steps of:

1. Mapping groups of B contiguous bits to real PAM symbols

2. Applying a first and a second rotation to the first and second group of D contiguous PAM symbols in a group of 2*D contiguous PAM symbols

3. Mapping the resulting D real symbols of the first group to D real or imaginary components of D adjacent complex cells, and mapping the resulting D real symbols to the remaining D components of said complex cells.

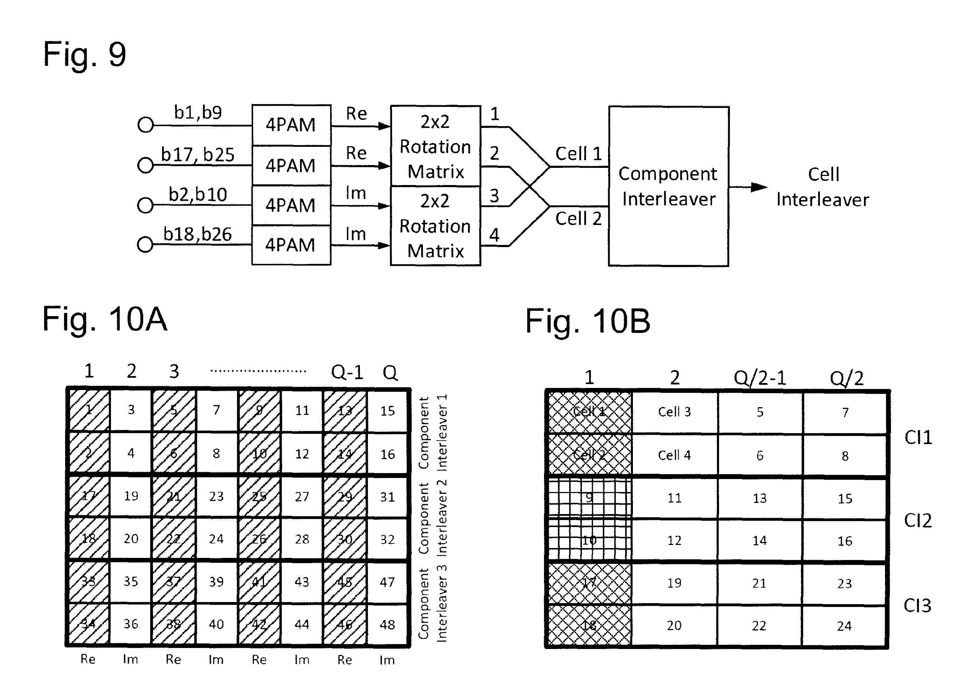

Figure 10A illustrates the layout of the PAM symbols in the component interleaver after this mapping. The numbers in the squares indicate the order of the PAM symbols. The hatched fields indicate the real-valued part of the subsequently transmitted cells.

In Figure 10B, PAM symbols have been paired into complex-valued cells, i.e., cell 1 consists of PAM symbols 1&3, cell 2 of PAM symbols 2&4 and so forth. This perspective on cells will highlight the problem of the conventional cell interleaver, as explained further below.

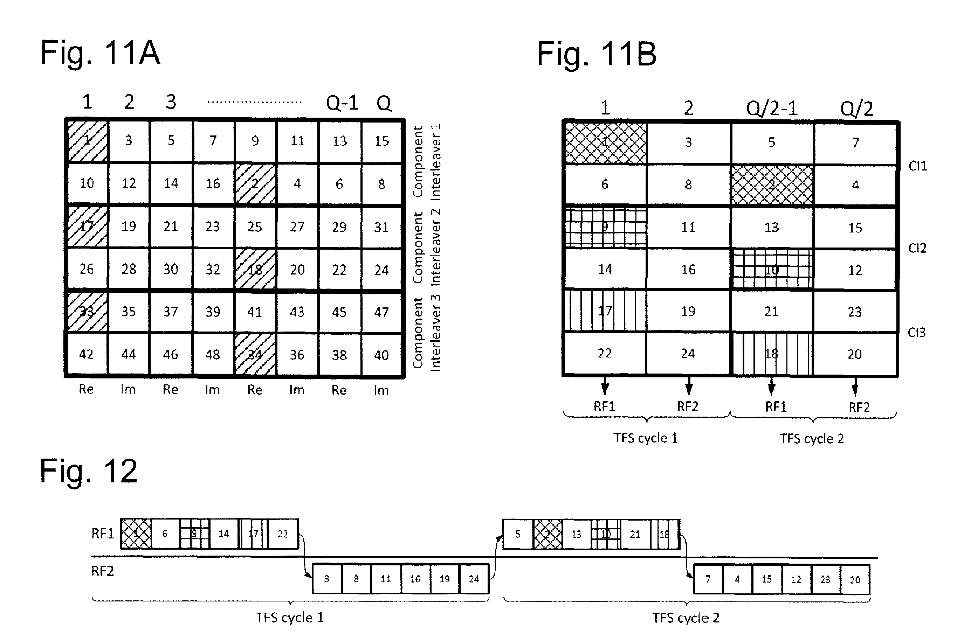

The operation of the conventional component interleaver is illustrated in Figures 11A and 11B, in which only the very first real-valued vector of a rotated constellation block is hatched. As shown in Figs. 11 A and 11B, an incremental shift by Q/D columns is applied to every other row.

To illustrate the problem of the prior art cyclic shift Q/D we assume that the cells ins Figure 11 are to be transmitted via TFS over two RF channels and two cycles, $N_{RF}=N_C =2$. This function is accomplished jointly by the combination of the row-column cell interleaver and the scheduler (cf. Figure 1) and results in a sequence of cells depicted in Figure 12.

The main problem of the conventional component interleaver in connection with TFS is that for some parameter combinations of D, $N_{RF}$ and $N_C$ constellation blocks are mapped on the same RF channel. For instance in Figure 12, cells 1&2, 9&10, and 17&18 each form a rotated constellation block and are transmitted on RF channel 1, which means in case of RF channel 1 being in a deep fade that the whole constellation block would be lost.

Therefore, there is a need for an improved component interleaver that distributes components of a rotated constellation block over all RF channels.

## SUMMARY OF THE INVENTION

The aim of the present invention is to provide an improved component interleaver that can be used in conjunction with TFS and allows for an efficient hardware implementation with parallel bit interleaving.

This is achieved by the features as set forth in the independent claims. Preferred embodiments are the subject matter of dependent claims.

According to a first aspect of the present invention, a method for transmitting digital data over a plurality of NRF frequency channels is provided. The method comprises the steps of encoding a block of data with a quasi-cyclic low-density parity-check code, resulting in a codeword consisting of N cyclic blocks, each cyclic block consisting of Q bits, the N cyclic blocks being grouped into a plurality of sections, each section consisting of M cyclic blocks, and a residual of at most M-1 cyclic blocks; mapping the bits of each section to a plurality of constellation blocks, each constellation block consisting of M bits, the mapping being performed such that each constellation block contains one bit of each cyclic block of the respective section; mapping each constellation block to a rotated constellation block consisting of D real-valued components, each component representing a coordinate of a corresponding D dimensional rotated constellation; mapping each component of the rotated constellation blocks to a frequency channel of the plurality of NRF frequency channels; and transmitting the components of the rotated constellation blocks over the corresponding frequency channel. The method is characterized in that the mapping of the components of the rotated constellation blocks to the frequency channels is equivalent to sequentially writing, for each section, the components of the rotated constellation blocks of said section column-by-column into a real-valued matrix having D rows and Q columns; converting, for each section, the real-valued matrix of said section into a complex-valued matrix having D rows and Q/2 columns by pair-wise combining horizontally adjacent entries of the real-valued matrix to a complex-valued entry of the complex-valued matrix; combining the complex-valued matrices of the plurality of floor(N/M) sections to a combined matrix having floor(N/M)*D rows and Q/2 columns by concatenating the complex-valued matrices in row direction; applying a cyclic shift to each row of the combined matrix such that the complex-valued entries of said row are rotated by a certain number, the certain number being cyclically selected for each row from a shift pattern comprising a set of integers greater than or equal to zero and less than Q/2; and sequentially mapping each column of the combined matrix to a frequency channel cyclically selected from the plurality of frequency channels, wherein the integers of the shift pattern are selected such that the components of each rotated constellation block are evenly distributed over the plurality of frequency channels.

According to a further aspect of the present invention, a method for receiving digital data over a plurality of NRF frequency channels is provided. The method comprises the steps of receiving a sequence of complex symbols in accordance with a predefined time-frequency slicing schedule over the plurality of frequency channels; mapping real and imaginary components of the sequence of complex symbols to real-valued components of a plurality of rotated constellation blocks; and decoding the plurality of rotated constellation blocks on the basis of a quasi-cyclic low-density parity-check code. The method is characterized in that the mapping of real and imaginary components of the sequence of complex symbols to real-valued components of the plurality of rotated constellation blocks is performed so as to revert the mapping of the components of rotated constellation blocks to frequency channels of the first aspect of the invention.

According to a further aspect of the present invention, a transmitter for transmitting digital data over a plurality of NRF frequency channels is provided. Said transmitter comprises an encoder for encoding a block of data with a quasi-cyclic low-density parity-check code, resulting in a codeword consisting of N cyclic blocks, each cyclic block consisting of Q bits, the N cyclic blocks being grouped into a plurality of sections, each section consisting of M cyclic blocks, and a residual of at most M-1 cyclic blocks; a bit interleaver for mapping the bits of each section to a plurality of constellation blocks, each constellation block consisting of M bits, the mapping being performed such that each constellation block contains one bit of each cyclic block of the respective section; a rotated constellation mapper for mapping each constellation block to a rotated constellation block consisting of D real-valued components, each component representing a coordinate of a corresponding D dimensional rotated constellation; a component interleaver for mapping each component of the rotated constellation blocks to a frequency channel of the plurality of NRF frequency channels; and a modulator for transmitting the components of the rotated constellation blocks over the corresponding frequency channel. The transmitter is characterized in that the component interleaver is adapted such that mapping of the components of the rotated constellation blocks to the frequency channels is equivalent to: sequentially writing, for each section, the components of the rotated constellation blocks of said section column-by-column into a real-valued matrix having D rows and Q columns; converting, for each section, the real-valued matrix of said section into a complex-valued matrix having D rows and Q/2 columns by pair-wise combining horizontally adjacent entries of the real-valued matrix to a complex-valued entry of the complex-valued matrix; combining the complex-valued matrices of the plurality of floor(N/M) sections to a combined matrix having floor(N/M)*D rows and Q/2 columns by concatenating the complex-valued matrices in row direction; applying a cyclic shift to each row of the combined matrix such that the complex-valued entries of said row are rotated by a certain number, the certain number being cyclically selected for each row from a shift pattern comprising a set of integers greater than or equal to zero and less than Q/2; and sequentially mapping each column of the combined matrix to a frequency channel cyclically selected from the plurality of frequency channels, wherein the integers of the shift pattern are selected such that the components of each rotated constellation block are evenly distributed over the plurality of frequency channels.

In a preferred embodiment, the shift pattern comprises at least one integer that is non-zero and a multiple of floor(Q/max{D,($N_{RF}$*$N_C$)}/2).

In another preferred embodiment, $D$ is equal to 2, and the shift pattern comprises at least one integer that is non-zero and a multiple of floor(Q/max{D,($N_{RF}$*$N_C$)}/2), but not a multiple of $N_{RF}$*floor(Q/max{D,($N_{RF}$*$N_C$)}/2).

In another preferred embodiment, $D$ is equal to 2 and every other integer in the shift pattern is equal to zero.

The above and other objects and features of the present invention will become more apparent from the following description and preferred embodiments given in conjunction with the accompanying drawings, in which:

Fig. 1     shows a schematic block diagram of a generic transmitter for rotated constellations;

Fig. 2     shows a parity-check matrix of an example quasi-cyclic LDPC code;

Fig. 3     shows a schematic block diagram of an example bit interleaver for quasi-cyclic LDPC codes;

Fig. 4A-C  illustrate row-column interleaving of each bit-interleaver section;

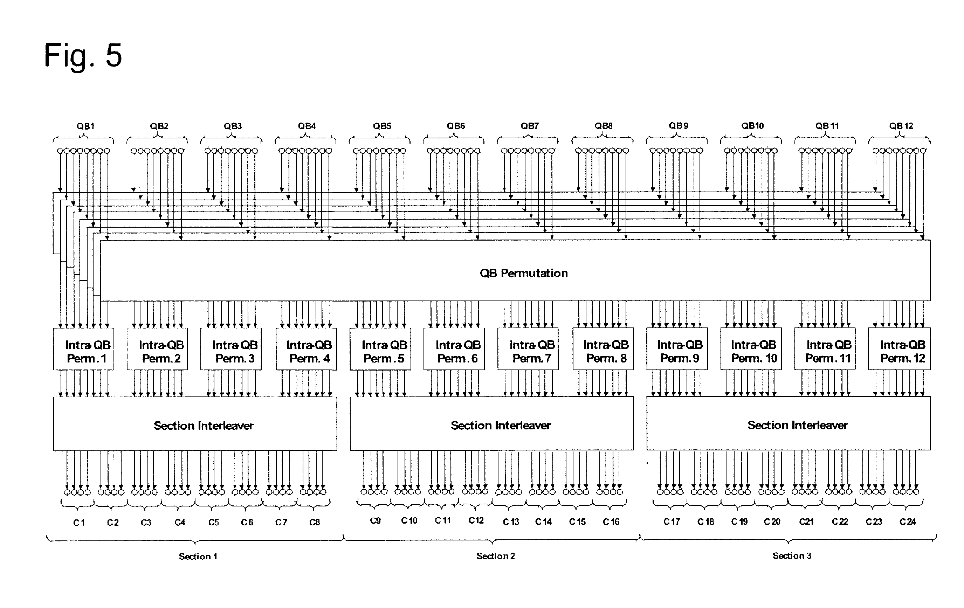

Fig. 5     shows a schematic block diagram of an example bit interleaver with additional QB and intra-QB permutations;

Fig. 6     illustrates time-frequency slicing with three RF channels;

Fig. 7     illustrates slicing a FEC block for TFS with three RF channels and three cycles;

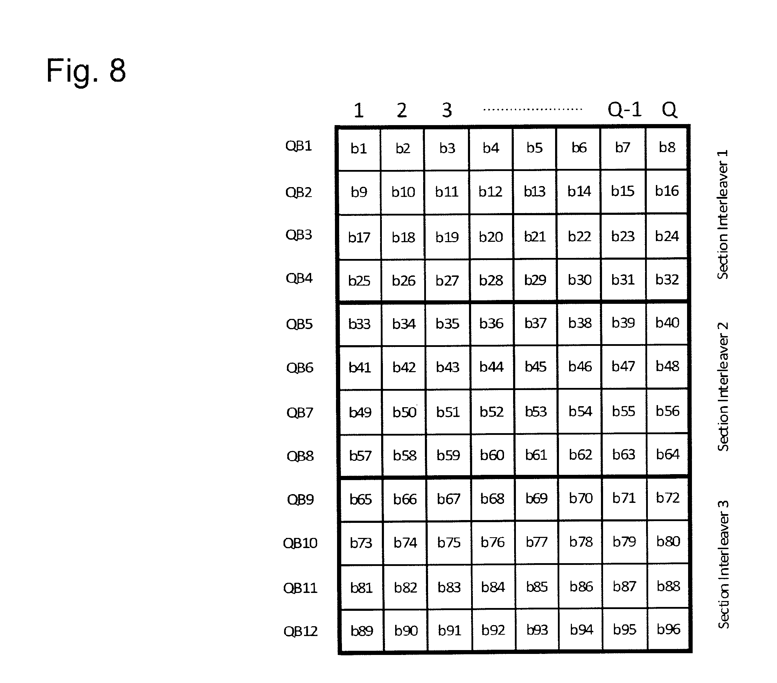

Fig. 8     shows an example section layout for three sections with Q=8 and B=2;

Fig. 9     is a schematic diagram, illustrating a mapping of interleaved bits to constellation blocks;

Fig. 10A   is a schematic diagram of a component interleaver from the perspective of PAM symbols;

Fig. 10B   is a schematic diagram of a component interleaver from the perspective of cells;

Fig. 11    is a schematic diagram of a component interleaver of Fig. 10A after cyclic shifting by Q/D;

Fig. 11B   is a schematic diagram of a component interleaver of Fig. 10B after cyclic shifting by Q/(2D);

Fig. 12    illustrates an example cell sequence for a conventional component interleaver;

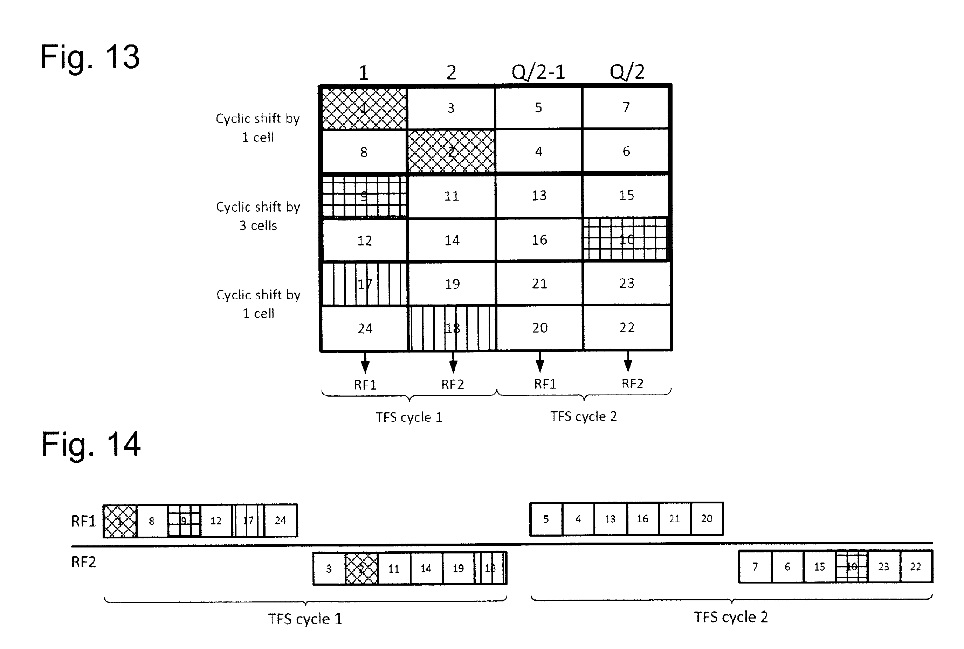

Fig. 13    illustrates skipping cyclic shift Q/D=2, according to an embodiment of the present invention;

Fig. 14    illustrates an example cell sequence for a component interleaver according to an embodiment of the present invention;

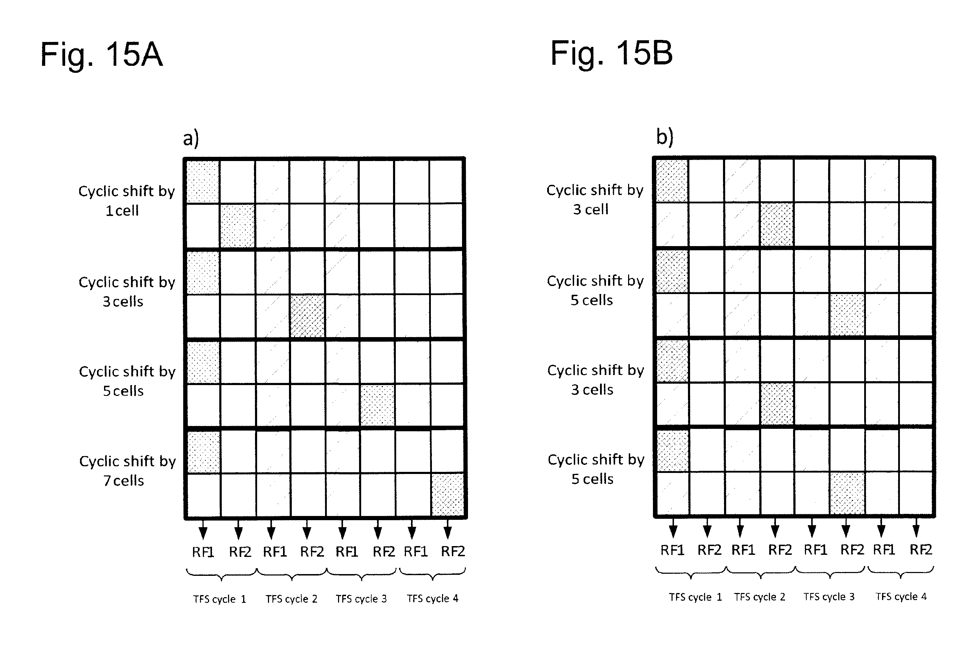

Fig. 15A   illustrates an example cyclic shift pattern for $N_{RF}$=2 and $N_C$=4, according to a first embodiment of the present invention;

Fig. 15B   illustrates an example of a shortened cyclic shift pattern for $N_{RF}$=2 and $N_C$=4, according to a second embodiment of the present invention;

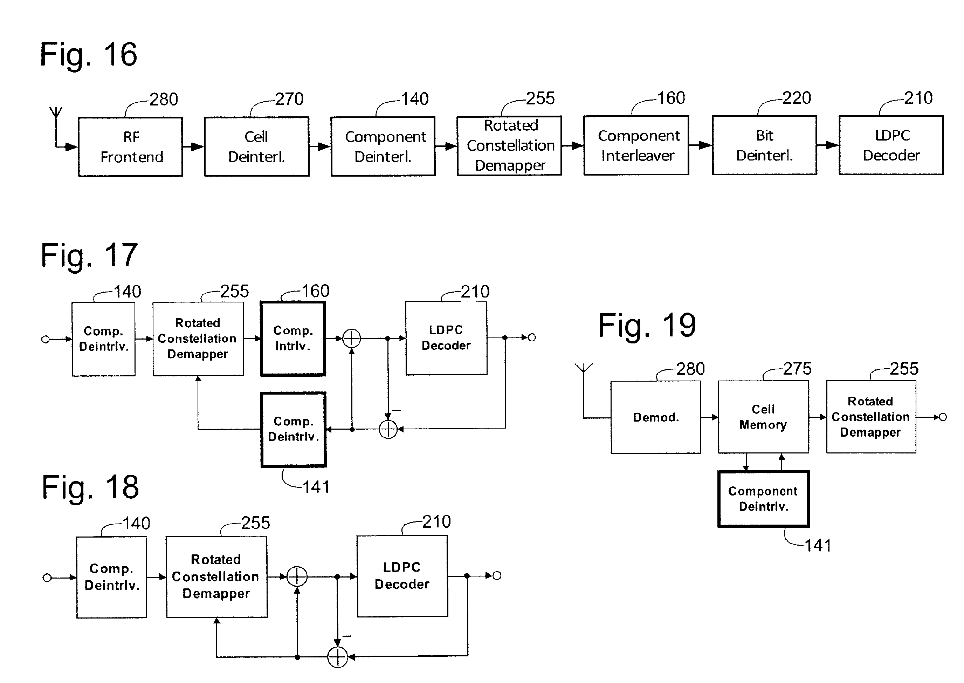

Fig. 16    shows a schematic block diagram of a generic receiver for rotated constellations;

Fig. 17    shows a schematic block diagram of a conventional iterative decoder;

Fig. 18    shows a schematic block diagram of an iterative decoder according to an embodiment of the present invention; and

Fig. 19    shows an implementation detail for the component interleaver in the receiver, according to an embodiment of the present invention.

## DETAILED DESCRIPTION

The main disadvantage of the conventional component interleaver is that it distributes the components of a constellation block inefficiently if applied to time-frequency-slicing, resulting in non-optimal performance.

From Figure 11B it is apparent that three cyclic shifts from the set {1, 2, 3} are possible. As evidenced in Figure 12, the cyclic shift (Q/2)/D=2 is disadvantageous since it leads to a mapping of all components into the same RF channel. However, if this cyclic shift is skipped and the remaining shifts {1, 3} are alternately applied, a section layout as illustrated in Figure 13 is obtained.

The cell sequence after time-frequency slicing in Figure 14 reveals the benefit of this improved component interleaver, i.e., the components of all rotated constellation blocks are distributed on different RF channels. For example, cell 1 is transmitted on RF channel 1 while cell 2 is transmitted on RF channel 2, etc. Hence, even if one of the RF channels is in a deep fade, the rotated constellation block might be successfully decoded on account of the other RF channel(s).

According to the present invention, the component interleaving is performed by applying appropriate cyclic shifts (between 0 and Q-1) to the cells of the individual rows in each component interleaver, so that the D cells of each constellation block are spread as evenly as possible over the FEC block. Embodiments of the present invention may differ with respect to the cyclic shifts employed and to how the cyclic shifts are computed. The corresponding de-interleaving is performed by applying the exact inverse cyclic shifts to said rows. In a preferred embodiment, the cyclic shifts are applied with cell granularity, i.e. the shifts are multiples of 2.

Implementing the component interleaving through cyclic shifts, as disclosed in the present invention, has the advantage of a significantly reduced hardware complexity, especially in the case of receivers with iterative decoding.

## Computing the cyclic shifts

In the following, cyclic shifts are referring to complex-valued cells rather than PAM symbols. A single cyclic shift corresponds to cyclically shifting

$$W=floor(Q/max\{D,(N_{RF}*N_C)\}/2)$$

cells in a row of the component interleaver. We refer to W as the width of a cyclic shift. The floor operator rounds its argument to the nearest integer towards minus infinity. All possible cyclic shifts can be taken from the set

$$\{0, W, 2*W\ldots, (max\{D,(N_{RF}*N_C)\}/2-1)*W\}.$$

There are parameter combinations by which the last TFS slice has a width different from all the others. That happens whenever Q is not divisible by $N_{RF}*N_C$, e.g., Q=360 and $N_{RF}=N_C=4$. In this case the slice width for all but the last slice may be chosen as

$$W=floor(Q/(N_{RF}*N_C)/2),$$

whereas the last slice has width rem(Q,W).

According to the first aspect of the invention, only those cyclic shifts from the set

$$\{0, W, 2*W\ldots, (max\{D,(N_{RF}*N_C)\}/2-1)*W\}$$

are actually used which shift subsequent components into neighboring RF channels while excluding those RF channels which already carry a component of the rotated constellation block. In cases, for which it is not possible to distribute components on separate RF channels, a best effort is made to separate components as evenly as possible over frequency and time. Table 1 and Table 2 show the corresponding cyclic shifts in the column "Cyclic shift pattern". The cyclic shift for each component interleaver row is found by using the row index modulo the number of cyclic shifts as an index into the given set of cyclic shifts.

*Table 1:* Shift patterns for D = 2

| NRF | TFS cycle | Cyclic shift pattern in units of floor(Q/max{D,($N_{RF}$*$N_C$)}/2) cells | Shortened shift pattern |
|---|---|---|---|
| 2 | 1 | 0,1 | - |
|  | 2 | 0,1,0,3 | - |
|  | 3 | 0,1,0,3,0,5 | 0,3 |
|  | 4 | 0,1, 0,3, 0,5, 0,7 | 0,3,0,5 |
| 3 | 1 | 0,1,0,2 | - |
|  | 2 | 0,1,0,2,0,4,0,5 | 0,2,0,4 |
|  | 3 | 0,1,0,2,0,4,0,5,0,7,0,8 | 0,4,0,5 |
|  | 4 | 0,1,0,2,0,4,0,5,0,7,0,8,0,10,0,11 | 0,5,0,7 |
| 4 | 1 | 0,1,0,2,0,3 | - |
|  | 2 | 0,1,0,2,0,3,0,5,0,6,0,7 | 0,2,0,3,0,5,0,3,0,5,0,6 |
|  | 3 | 0,1,0,2,0,3,0,5,0,6,0,7,0,9,0,10,0,11 | 0,3,0,6,0,9 |
|  | 4 | 0,1,0,2,0,3,0,5,0,6,0,7,0,9,0,10,0,11,0,13,0,14,0,15 | 0,5,0,6,0,7,0,9,0,10,0,11 |

*Table 2:* Shift patterns for D=4

| $N_{RF}$ | TFS cycle | Cyclic shift pattern in units of floor(Q/max{D,($N_{RF}$*$N_C$)}/2) cells | Shortened shift pattern |
|---|---|---|---|
| 2 | 1 | 0,1,2,3 | - |
|  | 2 | 0,1,2,3 | - |
|  | 3 | 0,1,2,3,0,4,5 | 0,2,3,5 |
|  | 4 | 0,1,2,3,0,4,5,6,0,7 | 0,2,5,7 |
| 3 | 1 | 0,1,2,3 | - |
|  | 2 | 0,1,2,3,0,4,5 | 0,1,2,4,0,2,4,5 |
|  | 3 | 0,1,2,3,0,4,5,6,0,7,8 | 0,3,5,7 |
|  | 4 | 0,1,2,3,0,4,5,6,0,7,8,9,0,10,11 | 0,4,6,8 |
| 4 | 1 | 0,1,2,3 | - |
|  | 2 | 0,1,2,3,0,5,6,7 | 0,2,3,5,0,3,5,6 |
|  | 3 | 0,1,2,3,0,5,6,7,0,9,10,11 | 0,5,0,6,0,7 |
|  | 4 | 0,1,2,3,0,5,6,7,0,9,10,11,0,13,14,15 | 0,5,6,7,0,9,10,11 |

Here, TFS cycle ($N_{TFS}$) is the number of changes between RF channels when transmitting one code word. For $N_{TFS}$=1 all RF channels are scanned once ($N_{RF}$=3: RF1 → RF2 → RF3), for $N_{TFS}$=2 all RF channels are scanned twice ($N_{RF}$=3: RFI → RF2 → RF3 → RF1 → RF2 → RF3), etc.

For D=2, the cyclic shifts can be computed according to

$$CyclicShift(s) = floor[ ((s-1)\%(N_{RF}-1)N_{TFS}) / (N_{RF}-1)] + (s-1)\%(N_{RF}-1)N_{TFS} + 1,$$

wherein "%" denotes the modulo operator.

**Shortened shift patterns**

In a second embodiment of the present invention, the set of cyclic shifts is restricted to those cyclic shifts that maximize the separation of components in time.

Figure 15B shows an example of shortened shift patterns for two RF channels, $N_{RF}$=2, and four TFS cycles, $N_C$=4. Figure 15A shows the cyclic shift pattern according to the first embodiment of the invention, i.e, {0, 1, 0, 3, 0, 5, 0, 7}, while Figure 15B shows the shortened cyclic shift pattern (0, 3, 0, 5). Both patterns provide the same mean cyclic shift (here 4), but the variance of the cyclic shifts of the shortened pattern is much smaller (here 2, rather than 6.667).

Table 1 and Table 2 show the corresponding cyclic shifts in the column "Shortened shift pattern". The cyclic shift for each component interleaver row is found by using the row index modulo the number of cyclic shifts as an index into the given set of cyclic shifts.

### Dealing with residual cyclic blocks

An important corner case arises when the number of bits per codeword is not divisible by the number of bits per rotated (complex-valued) constellation block, $2*B*D$. This issue can be dealt with by excluding the remaining cyclic blocks from section interleaving. A similar workaround is also disclosed in reference EP 2 525 497 (A1).

Tables 3 and 4 show the number of sections and the number of excluded QBs for 16k and 64k LDPC codewords typically employed in DVB-T2 and DVB-NGH.

Table 3: Number of sections and of excluded QBs for 16k LDPC codewords

| D | B | Modulation | Number of sections | Number of excluded QBs |
|---|---|---|---|---|
| 2 | 1 | QPSK | 11 | 1 |
| | 2 | 16QAM | 5 | 5 |
| | 3 | 64QAM | 3 | 9 |
| | 4 | 256QAM | 2 | 15 |
| 4 | 1 | QPSK | 5 | 5 |
| | 2 | 16QAM | 2 | 13 |
| | 3 | 64QAM | 1 | 21 |
| | 4 | 256QAM | 1 | 13 |

*Table 4: Number of sections and of excluded QBs for 64k LDPC codewords*

| D | B | Modulation | Number of sections | Number of excluded QBs |
|---|---|---|---|---|
| 2 | 1 | QPSK | 45 | 0 |
| | 2 | 16QAM | 22 | 4 |
| | 3 | 64QAM | 15 | 11 |
| | 4 | 256QAM | 0 | 4 |
| 4 | 1 | QPSK | 22 | 4 |
| | 2 | 16QAM | 11 | 4 |
| | 3 | 64QAM | 7 | 12 |
| | 4 | 256QAM | 5 | 20 |

The excluded QB bits may be mapped in any suitable manner. Moreover, the TFS schedule for these non-rotated cells may also be chosen in any suitable manner. In a non-limiting example, the less important parity bits may be selected as bits to be excluded, mapped to the mother constellation without rotation, and transmitted on one RF channel on the last TFS slice.

### Receiver

The receiver mirrors the functionality of the transmitter. The schematic block diagram for the receiver is shown in Figure 16. Note that this diagram is the mirrored version of the transmitter in Figure 1, in which the counterpart of PAM mapper and the constellation rotation is merged into a single block, the rotated constellation demapper.

In the receiver block diagram of Figure 16 the component deinterleaver 140 is applied to complex symbols (cells), whereas the matching interleaver 160 is applied to demapped (soft) bits. The cyclic shifts of the component interleaver 160 can be merged into the cyclic shifts of the bit deinterleaver 220, which in turn can be merged into the definition of the LDPC code 210. The component interleaver requires therefore no hardware.

This is particularly advantageous for receivers that employ iterative decoding. The generic block diagram of such a decoder is shown in Figure 17. A bit interleaver and de-interleaver were not included because they require no hardware.

The essence of iterative decoding is that the demapping and the LDPC decoding are performed iteratively in a loop, the loop therefore closing over any blocks that come in between. Iterative decoding is a technique well-known in the art.

Since the component interleaver and deinterleaver are part of the iterative decoding loop, the implementation can be greatly simplified if the component interleaver 160 is performed according to the invention, i.e. using cyclic shifts. As mentioned before, the cyclic shifts can be merged together with the cyclic shifts of the bit interleaver into the definition of the LDPC decoder. Thus, no blocks come between the demapper 255 and the LDPC decoder 210, as illustrated in Figure 18. This enables the two blocks to be coupled more tightly, so that they can exchange data with no latency.

In addition to the optimization of the iterative decoding loop, the invention also enables an efficient implementation of the component interleaver, which is outside the loop. How this can be done is illustrated in Figure 19.

For each row in, e.g., Figure 13, the $Q/2$ cells of that row are read from a cell memory 275, cyclically shifted according to the invention, and written back to the cell memory 275 in place, i.e. at the same addresses they were read from. No additional memory is therefore required and the latency is very low as the interleaving is performed row by row instead of over the whole LDPC block.

**Claims**

1. A method for transmitting digital data over a plurality of $N_{RF}$ frequency channels, said method comprising the steps of:

   encoding a block of data with a quasi-cyclic low-density parity-check code, resulting in a codeword consisting of $N$ cyclic blocks, each cyclic block consisting of $Q$ bits, the $N$ cyclic blocks being grouped into a plurality of sections, each section consisting of $M$ cyclic blocks, and a residual of at most $M-1$ cyclic blocks;
   mapping the bits of each section to a plurality of constellation blocks, each constellation block consisting of $M$ bits, the mapping being performed such that each constellation block contains one bit of each cyclic block of the respective section;
   mapping each constellation block to a rotated constellation block consisting of $D$ real-valued components, each component representing a coordinate of a corresponding $D$ dimensional rotated constellation;
   mapping each component of the rotated constellation blocks to a frequency channel of the plurality of $N_{RF}$ frequency channels;
   transmitting the components of the rotated constellation blocks over the corresponding frequency channel,
   **characterized in that** the mapping of the components of the rotated constellation blocks to the frequency channels is equivalent to:

      sequentially writing, for each section, the components of the rotated constellation blocks of said section column-by-column into a real-valued matrix having $D$ rows and $Q$ columns;
      converting, for each section, the real-valued matrix of said section into a complex-valued matrix having $D$ rows and $Q/2$ columns by pair-wise combining horizontally adjacent entries of the real-valued matrix to a complex-valued entry of the complex-valued matrix;
      combining the complex-valued matrices of the plurality of floor($N/M$) sections to a combined matrix having floor$(N/M*)$ $D$ rows and $Q/2$ columns by concatenating the complex-valued matrices in row direction;
      applying a cyclic shift to each row of the combined matrix such that the complex-valued entries of said row are rotated by a certain number, the certain number being cyclically selected for each row from a shift pattern comprising a set of integers greater than or equal to zero and less than $Q/2$;
      sequentially mapping each column of the combined matrix to a frequency channel cyclically selected from the plurality of frequency channels,
      wherein the integers of the shift pattern are selected such that the components of each rotated constellation block are evenly distributed over the plurality of frequency channels.

2. A method according to claim 1, wherein the shift pattern comprises at least one integer that is non-zero and a multiple of floor($Q/\max\{D, (N_{RF}*N_C)\}/2$).

3. A method according to claim 1, wherein $D$ is equal to 2, and wherein the shift pattern comprises at least one integer that is non-zero and a multiple of floor($Q/\max\{D, (N_{RF}*N_C)\}/2$), but not a multiple of $N_{RF}*$floor($Q/\max\{D, (N_{RF}*N_C)\}/2$).

4. A method according to any of claims 1 to 3, wherein $D$ is equal to 2, and wherein every other integer in the shift pattern is equal to zero.

5. A method for receiving digital data over a plurality of $N_{RF}$ frequency channels, said method comprising the steps of:

receiving a sequence of complex symbols in accordance with a predefined time-frequency slicing schedule over the plurality of frequency channels;

mapping real and imaginary components of the sequence of complex symbols to real-valued components of a plurality of rotated constellation blocks;

decoding the plurality of rotated constellation blocks on the basis of a quasi-cyclic low-density parity-check code, **characterized in that**

the mapping of real and imaginary components of the sequence of complex symbols to real-valued components of the plurality of rotated constellation blocks is performed so as to revert the mapping of the components of rotated constellation blocks to frequency channels defined in any of claims 1 to 4.

6. A transmitter for transmitting digital data over a plurality of $N_{RF}$ frequency channels, said transmitter comprising:

an encoder (110) for encoding a block of data with a quasi-cyclic low-density parity-check code, resulting in a codeword consisting of $N$ cyclic blocks, each cyclic block consisting of $Q$ bits, the $N$ cyclic blocks being grouped into a plurality of sections, each section consisting of $M$ cyclic blocks, and a residual of at most $M-1$ cyclic blocks;

a bit interleaver (120) for mapping the bits of each section to a plurality of constellation blocks, each constellation block consisting of $M$ bits, the mapping being performed such that each constellation block contains one bit of each cyclic block of the respective section;

a rotated constellation mapper (130, 150) for mapping each constellation block to a rotated constellation block consisting of $D$ real-valued components, each component representing a coordinate of a corresponding $D$ dimensional rotated constellation;

a component interleaver (160) for mapping each component of the rotated constellation blocks to a frequency channel of the plurality of $N_{RF}$ frequency channels;

a modulator (190-1,...,190-n) for transmitting the components of the rotated constellation blocks over the corresponding frequency channel,

**characterized in that** the component interleaver (160) is adapted such that mapping of the components of the rotated constellation blocks to the frequency channels is equivalent to:

sequentially writing, for each section, the components of the rotated constellation blocks of said section column-by-column into a real-valued matrix having $D$ rows and $Q$ columns;

converting, for each section, the real-valued matrix of said section into a complex-valued matrix having $D$ rows and $Q/2$ columns by pair-wise combining horizontally adjacent entries of the real-valued matrix to a complex-valued entry of the complex-valued matrix;

combining the complex-valued matrices of the plurality of floor($N/M$) sections to a combined matrix having floor($N/M$)*$D$ rows and $Q/2$ columns by concatenating the complex-valued matrices in row direction;

applying a cyclic shift to each row of the combined matrix such that the complex-valued entries of said row are rotated by a certain number, the certain number being cyclically selected for each row from a shift pattern comprising a set of integers greater than or equal to zero and less than $Q/2$;

sequentially mapping each column of the combined matrix to a frequency channel cyclically selected from the plurality of frequency channels,

wherein the integers of the shift pattern are selected such that the components of each rotated constellation block are evenly distributed over the plurality of frequency channels.

7. A transmitter according to claim 6, wherein the shift pattern comprises at least one integer that is non-zero and a multiple of floor(Q/max{D, ($N_{RF}$*$N_C$)}/2).

8. A transmitter according to claim 6, wherein $D$ is equal to 2, and wherein the shift pattern comprises at least one integer that is non-zero and a multiple of floor(Q/max(D, ($N_{RF}$*$N_C$)}/2), but not a multiple of $N_{RF}$*floor(Q/max{D, ($N_{RF}$*$N_C$)}/2).

9. A transmitter according to any of claims 6 to 8, wherein $D$ is equal to 2, and wherein every other integer in the shift pattern is equal to zero.

10. A receiver for receiving digital data over a plurality of $N_{RF}$ frequency channels, said receiver comprising:

an RF-frontend (280) for receiving a sequence of complex symbols in accordance with a predefined time-frequency slicing schedule over the plurality of frequency channels;

a component deinterleaver (140) for mapping real and imaginary components of the sequence of complex symbols to real-valued components of a plurality of rotated constellation blocks;
a decoder (210) for decoding the plurality of rotated constellation blocks on the basis of a quasi-cyclic low-density parity-check code,
**characterized in that**
the component deinterleaver (140) is adapted such that the mapping of real and imaginary components of the sequence of complex symbols to real-valued components of the plurality of rotated constellation blocks is performed so as to revert the mapping of the components of rotated constellation blocks to frequency channels defined in any of claims 1 to 4.

Fig. 1

Fig. 2

## Fig. 3

QB1  QB2  QB3  QB4    QB5  QB6  QB7  QB8    QB9  QB10  QB11  QB12

Permutation    Permutation    Permutation

C1  C2  C3  C4  C5  C6  C7  C8    C9  C10  C11  C12  C13  C14  C15  C16    C17  C18  C19  C20  C21  C22  C23  C24

Section 1    Section 2    Section 3

## Fig. 4A

QB1    QB2    QB3    QB4

C1    C2    C3    C4    C5    C6    C7    C8

## Fig. 4B

QB1 → $b_1$    Input
QB2
QB3
QB4

## Fig. 4C

$b_1$    Output

C1  C2  C3  C4  C5  C6  C7  C8

Fig. 5

EP 2 879 318 A1

# Fig. 6

Cycle 1

Cycle 2

Cycle 3

# Fig. 7

| Slice 1 | Slice 2 | Slice 3 | Slice 4 | Slice 5 | Slice 6 | Slice 7 | Slice 8 | Slice 9 |
|---------|---------|---------|---------|---------|---------|---------|---------|---------|
| RF 1 | RF 2 | RF 3 | RF 1 | RF 2 | RF 3 | RF 1 | RF 2 | RF 3 |

TFS cycle 1          TFS cycle 2          TFS cycle 3

Fig. 8

| | 1 | 2 | 3 | ·················· | Q-1 | Q | |
|---|---|---|---|---|---|---|---|
| QB1 | b1 | b2 | b3 | b4 | b5 | b6 | b7 | b8 |
| QB2 | b9 | b10 | b11 | b12 | b13 | b14 | b15 | b16 |
| QB3 | b17 | b18 | b19 | b20 | b21 | b22 | b23 | b24 |
| QB4 | b25 | b26 | b27 | b28 | b29 | b30 | b31 | b32 |
| QB5 | b33 | b34 | b35 | b36 | b37 | b38 | b39 | b40 |
| QB6 | b41 | b42 | b43 | b44 | b45 | b46 | b47 | b48 |
| QB7 | b49 | b50 | b51 | b52 | b53 | b54 | b55 | b56 |
| QB8 | b57 | b58 | b59 | b60 | b61 | b62 | b63 | b64 |
| QB9 | b65 | b66 | b67 | b68 | b69 | b70 | b71 | b72 |
| QB10 | b73 | b74 | b75 | b76 | b77 | b78 | b79 | b80 |
| QB11 | b81 | b82 | b83 | b84 | b85 | b86 | b87 | b88 |
| QB12 | b89 | b90 | b91 | b92 | b93 | b94 | b95 | b96 |

Section Interleaver 1

Section Interleaver 2

Section Interleaver 3

**Fig. 9**

**Fig. 10A**

**Fig. 10B**

# Fig. 11A

| | 1 | 2 | 3 | | | | | Q-1 | Q |
|---|---|---|---|---|---|---|---|---|---|
| | Re | Im | Re | Im | Re | Im | Re | Im |
| | 42 | 44 | 46 | 48 | 34 | 36 | 38 | 40 |
| | 33 | 35 | 37 | 39 | 41 | 43 | 45 | 47 |
| | 26 | 28 | 30 | 32 | 25 | 20 | 22 | 24 |
| | 17 | 19 | 21 | 23 | 9 | 27 | 29 | 31 |
| | 10 | 12 | 14 | 16 | 2 | 4 | 6 | 8 |
| | 1 | 3 | 5 | 7 | | 11 | 13 | 15 |

Component          Component          Component
Interleaver 3      Interleaver 2      Interleaver 1

# Fig. 11B

| | 1 | 2 | Q/2-1 | Q/2 | |
|---|---|---|---|---|---|
| | 1 | 3 | 5 | 7 | CI1 |
| | 9 | 8 | 2 | 4 | CI2 |
| | 6 | 11 | 13 | 15 | |
| | 14 | 16 | 10 | 12 | |
| | 17 | 19 | 21 | 23 | CI3 |
| | 22 | 24 | 18 | 20 | |

RF1  RF2      RF1  RF2

TFS cycle 1      TFS cycle 2

# Fig. 12

RF1  | 1 | 6 | 9 | 14 | 17 | 22 |

RF2

TFS cycle 1

| 3 | 8 | 11 | 16 | 19 | 24 |

| 5 | 13 | 10 | 21 | 18 |

TFS cycle 2

| 7 | 4 | 15 | 12 | 23 | 20 |

# Fig. 13

| 1 | 2 | Q/2-1 | Q/2 |

Cyclic shift by 1 cell — 8 — 3 — 5 — 7

Cyclic shift by 3 cells — 12 — 11 — 13 — 15

Cyclic shift by 1 cell — 17 — 14 — 16 — 6

— 24 — 19 — 21 — 23

— 9 — 2 — 4 — 6

— 18 — 20 — 22

RF1 ← RF2 ←  (TFS cycle 1)
RF1 ← RF2 ←  (TFS cycle 2)

# Fig. 14

RF1: 8 | 9 | 12 | 17 | 24 — 3 | 2 | 11 | 14 | 19 | 18 — 5 | 4 | 13 | 16 | 21 | 20 — 7 | 6 | 15 | 10 | 23 | 22

RF2:

TFS cycle 1 — TFS cycle 2

Fig. 15A

Fig. 15B

Fig. 16

Fig. 17

Fig. 18

Fig. 19

Europäisches
Patentamt

European
Patent Office

Office européen
des brevets

# EUROPEAN SEARCH REPORT

Application Number

EP 13 19 5168

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 2 618 532 A1 (PANASONIC CORP [JP]) 24 July 2013 (2013-07-24) * the whole document * | 1-10 | INV. H04L1/00 H03M13/11 H03M13/27 H04L27/26 H04L5/00 |
| A | US 2007/019747 A1 (ALDANA CARLOS [US]) 25 January 2007 (2007-01-25) * page 3, right-hand column, paragraph 51 - page 5, right-hand column, paragraph 80; figures 5-10 * | 1-10 | |
| A | WO 2005/029759 A2 (INTEL CORP [US]) 31 March 2005 (2005-03-31) * page 5, line 11 - page 8, line 29; figures 1-4 * | 1-10 | |

TECHNICAL FIELDS
SEARCHED        (IPC)

H04L
H03M

The present search report has been drawn up for all claims

| Place of search | Date of completion of the search | Examiner |
|---|---|---|
| Munich | 23 April 2014 | Courville, Nicolas |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 13 19 5168

This annex lists the patent family members relating to the patent documents cited in the above-mentioned European search report.
The members are as contained in the European Patent Office EDP file on
The European Patent Office is in no way liable for these particulars which are merely given for the purpose of information.

23-04-2014

| Patent document cited in search report | | Publication date | Patent family member(s) | | Publication date |
|---|---|---|---|---|---|
| EP 2618532 | A1 | 24-07-2013 | CN | 103493450 A | 01-01-2014 |
| | | | EP | 2618532 A1 | 24-07-2013 |
| | | | US | 2014056330 A1 | 27-02-2014 |
| | | | WO | 2013108617 A1 | 25-07-2013 |
| US 2007019747 | A1 | 25-01-2007 | US | 2007019747 A1 | 25-01-2007 |
| | | | US | 2010246717 A1 | 30-09-2010 |
| WO 2005029759 | A2 | 31-03-2005 | JP | 4396993 B2 | 13-01-2010 |
| | | | JP | 2007506304 A | 15-03-2007 |
| | | | KR | 20060039452 A | 08-05-2006 |
| | | | TW | I276317 B | 11-03-2007 |
| | | | US | 2005058217 A1 | 17-03-2005 |
| | | | WO | 2005029759 A2 | 31-03-2005 |

EPO FORM P0459

**REFERENCES CITED IN THE DESCRIPTION**

**Patent documents cited in the description**

- EP 09168370 A
- EP 12178274 A
- EP 2525497 A1
- EP 12178270 A